# EUROPEAN PATENT APPLICATION

(11) **EP 2 993 613 A1**
(43) Date of publication of application: **09.03.2016**
(21) Application number: 14183571.0
(22) Date of filing: 04.09.2014
(51) Int. Cl.: G06K 9/00

(54) **A capture system arranged to create a 3d model from a scanned scene, a method and a graphical user interface**

(71) Applicant: Fujitsu Limited, Kawasaki-shi, Kanagawa 211-8588 (JP)
(72) Inventor: Georgescu, Serban, London, Greater London W5 3JY (GB); Kuraishi, Hideaki, London, Greater London W3 9BE (GB); Abdurrahman, Muhammad, London, Greater London E14 8NB (GB); Kubota, Tetsuyuki, London, Greater London W3 0NX (GB); Chow, Peter, Gillingham, Kent ME7 3AH (GB)
(74) Representative: Wilding, Frances Ward

(57) **Abstract**

A capture system arranged to create a 3D model from a scene comprises: an input from a 3D capture device which captures sets of points in the scene corresponding to scene boundaries and one or more scene elements; a Graphical User Interface, GUI configured to allow input of a set of points specifically as boundary points and configured to allow input of a set of points specifically as element points; a boundary capture module configured to process sets of boundary points captured on the boundaries and to compute the geometry of the boundaries of the 3D model; and a content capture module configured to process the set of element points captured on an element of the scene contents and to match the captured points for the element against element models in a model database.

## Description

The present invention relates to 3D capture of points in space corresponding to a scene and construction of a model from the captured points.

The creation of a 3D computer model from a real world scene is a process known and used for a long time. Virtual tours, planning before purchase, computer games and various types of simulation are just a few examples of applications that make use of such computer models. In general, computer models are manually created using specialized software like Architect 3D, Sweet Home 3D or Google Sketchup. This process is tedious and time consuming as it requires manual measurements and modelling.

In recent years, 3D capturing devices have made model creation easier by enabling the creator to directly scan real world scenes with a camera and convert them to 3D models, for example by capturing points scanned on solid objects/planes. With the help of software tools like Skanect, ReconstructMe or KinectFusion, model creators can use consumer level 3D capturing devices like the Microsoft Kinect to create 3D models of rooms together with the objects they contain. These 3D models describe the geometry using large numbers of 3D points (to form a so-called point cloud) or triangles (forming a surface mesh). Most 3D capturing devices, including Microsoft Kinect and Occipital Structure Sensor, have the capability of capturing color information together with the 3D (height, width and depth) position information. In this way, for each point that is captured, not only its coordinates in 3D space but also its color can be recorded.

The creation of a 3D model from a real world scene using current software like Skanect, ReconstructMe or KinectFusion is still a slow process. For scanning an entire room together with the contents, the current approach to scanning is in 4 steps:
1. Scan the entire scene including the room and its contents.
2. Run a segmentation algorithm to detect the floor, ceiling, walls and individual objects (to distinguish the points on an object or surface from points on other objects and surfaces).
3. Perform an optional step of 3D object recognition.
4. Build the model from either the segmented objects or from the recognized models/objects.

It is desirable to improve this methodology. In an embodiment of a first aspect of the present invention there is provided a capture system arranged to create a 3D model from a scene and comprising: an input from a 3D capture device which captures sets of points in the scene corresponding to scene boundaries and one or more scene elements; a Graphical User Interface, GUI configured to allow input of a set of points specifically as boundary points and configured to allow input of a set of points specifically as element points; a boundary capture module configured to process sets of boundary points captured on the boundaries and to compute the geometry of the boundaries of the 3D model; and a content capture module configured to process the set of element points captured on an element of the scene contents and to match the captured points for the element against element models in a model database.

In this aspect, embodiments provide a capture system (or apparatus) which uses an input from a 3D capture device (such as a camera and software to scan and capture sets of points in the scene). The sets of points can correspond to scene boundaries and to one or more scene elements. For example the boundaries may be delimiting planes of an enclosed or partially enclosed or otherwise determined space and scene elements can be objects within the enclosed space.

The capture system includes a GUI which allows the user to input the points specifically as boundary points. The GUI also allows the user to input the points specifically as element points. Hence there is, at the input stage, already a distinction between points which define the boundary of the scene and points which define objects within the scene.

The capture system includes a boundary capture module specifically to process the boundary points and this allows the geometry of the boundaries of the 3D model to be computed. The capture system also includes a content capture module which processes the set of element points captured on an element of the scene contents (this process can take place separately for each set of element points captured for each different element of the scene content). This content capture module also matches these captured points on the element against element models in a model database.

The separate capture and processing of boundary points and element points allows the system to transform a real-world scene efficiently to a model of the scene.

Some of the drawbacks of the prior art are:
a. Scanning the complete scene (e.g. room) model is very slow (in the order of hours) because the entire scene geometry needs to be captured.
b. During scanning, there is no way to know when an object has been scanned "well enough" to be recognized later.
c. Segmentation is difficult because the entire scene needs to be processed.
d. There is a high risk that some objects were not scanned well enough for accurate recognition to be possible. If that is the case, partial or complete re-scanning of the scene is required.

Separate input and processing of the boundary and element points allows these drawbacks to be overcome, or at least mitigated. Once the 3D model has been created, the system may also carry out simulation, such as heat propagation simulation or light propagation simulation. Any simulation may alternatively be carried out by a separate system. Equally the 3D capture device may be part of the capture system or may be provided separately.

As set out above, the scene may be any kind of space (and the boundaries may be physical or simply notional and defined, for example, by user input or a standard scene size). In preferred embodiments the scene is a room (that is, a space within a structure distinguishable by boundaries) such as a room in a house, or a hall or hanger or workshop or any other room which may or may not have a complete set of walls, floor and ceiling. If the room includes all these boundaries, the boundary capture module may be configured to process boundary points for the walls, ceiling and floor in combination to compute the wall geometry by fitting intersecting surfaces through sets of points. For example, one set of one or more points may be input for each wall, one for the ceiling and one for the floor. Either the system can differentiate automatically between the sets of points for the different boundaries, or the user can indicate when the points for each boundary are complete using the GUI.

The scene may include doors and windows on the boundaries (and forming parts of the boundaries). The boundary capture module may be configured to compute the positions of any doors and windows once the wall geometry has been computed. Computation of the door and window positions may be by using 3D coordinate information and/or colour information. To allow for the possibility that a door may be a similar or identical colour to the surrounding wall, the GUI may be configured to instruct the user to leave any doors opened or partially opened. This allows a distinction between the door and surrounding wall.

The computed geometry for the boundaries may be calculated using any suitable method. Preferably, the capture system further comprises a database configured to store a default scene model; the boundary capture module can then be configured to base the computed geometry of the boundaries of the 3D model on the default scene model.

The default scene model may be a simple room with a flat parallel floor and ceiling and a number of straight walls giving a polygon horizontal cross-section of the scene. When points are captured on the different boundaries, these assumptions allow these boundaries to be quickly and easily constructed in the model.

The boundary capture module and content capture module are likely to act sequentially, probably with the boundary capture module acting first. However both modules may act in parallel. In the boundary capture module all the sets of points corresponding to the different boundaries may be processed together as a point cloud to compute the geometry. Alternatively each boundary may be processed separately, usually in order of capture. For the content capture module, on the other hand, it is advisable to process one set of element points (corresponding to a single element in the scene) and to add an element to the 3D model before processing the next set of element points.

If, as will usually be the case, the boundaries are captured before the elements within the scene, the content capture module may be configured to subtract from the sets of element points currently being processed, any point belonging to a previously captured boundary or previously captured scene element. This may be achieved by computing which points from the current captured set fall on entities (boundaries or elements) in the as-yet incomplete 3D model. Once an element has been added to the 3D model or the geometry of the boundaries has been computed, this computation should be quite straightforward.

Preferably, the GUI is configured to allow input of the boundary points and computation (and display) of the geometry of the boundaries of the 3D model before input of the element points. For example, the GUI may be provided with a set order of processing which is followed automatically.

In the content capture phase, the GUI may be configured to allow the user to select an element model for insertion in the 3D model, from pre-selected element models in the model database which match the captured element points on an element. For example, the element models in the model database may represent common objects in scenes, such as furniture in rooms or machines in a manufacturing hall. The captured element points can be used to pre-select element models by geometrical comparison of the points with the models.

Of course it may be that the pre-selected element models do not correspond to the real life object being scanned, in which case the user will wish to continue scanning the element in more detail. Hence the GUI may be configured to allow the user to reject all of the pre-selected element models and to continue capturing points on the element.

The content capture module allows the captured points for each element to be matched against element models, but the database and matching may be external or internal. In one arrangement, the content capture module is configured to match the captured element points on an element against element models in a model database and to provide a matching score by which up to N candidate element models are preselected. For example N may be a number under 10 allowing easy viewing of the candidate element models of the GUI. A matching score can be any which reflects geometrical similarities of the element points and the element models in the model database.

Alternatively, an external matching service may be provided. In this case the content capture module may be configured to match the captured points on an element by sending the set of points to an external matching service and receiving one or more matched element models or the network location of one or more matched element models in return. Thus the matching surface may directly provide the matched element models, (which may also be up to N candidate element models) or the external matching service may simply indicate the location of such models.

Invention embodiments may simply have two categories of captured points, boundary points and element points. In some embodiments however, there may be a third category of points in the form of special element points. These relate to elements of particular interest, which may have different attributes from the other element points. They may be captured using a different capturing algorithm from a standard capturing algorithm. In such an embodiment there may be provided a special element capture module configured to process special element points captured on predefined special elements of the scene contents using a different capturing algorithm from a capturing algorithm used for other element points. This module may be configured to match the captured element points for each predefined special element against special element models in a model database. The same model database may be provided as for the other element points or a special model database may be provided. The different capturing algorithm may for example take into account extra or alternative features of the special elements points for example to take into account light emission of lighting fixtures which could be considered as a special element.

There may be 3 stages of capture; a stage of boundary capture, a stage of content capture and an optional stage of special element capture (which is essentially the same as content capture, but may differ in details such as in the capturing algorithm used). The GUI may be configured to allow the user to input when a stage of boundary capture and/or contents capture and/or special element capture is complete. For example, there may be a "move to next stage" button provided on the GUI or a question as to whether the current stage is complete.

The previous aspect related to a capture system or apparatus. The second aspect of the present invention concerns a related method of creating a 3D model from a scanned scene.

According to an embodiment of the second aspect of the invention there is provided a method of creating a 3D model from a scene having scene boundaries and one or more scene elements, the method comprising: inputting via a Graphical User Interface, GUI a set of boundary points for each scene boundary corresponding to the boundary from a 3D capture device; and processing the sets of boundary points captured on all the boundaries and computing the geometry of the boundaries of the 3D model; and subsequently for each scene element: inputting via a GUI a set of points corresponding to the scene element from the 3D capture device; and processing the set of element points captured on the element and matching the captured points against element models in a model database.

In this method, use of the GUI to provide separate boundary points and element points may be specifically by subsequent processing of the scene elements after the boundary computation. Each scene element is processed separately.

A third aspect relates to a GUI. According to an embodiment of a third aspect there is provided a Graphical User Interface, GUI, in a capture system arranged to create a 3D model from a scene with scene boundaries and one or more scene elements using a 3D capture device which captures sets of points in the scene; wherein the GUI is configured: to allow the input of one set of points specifically as boundary points and the input of another set of points specifically as element points; to display the sets of boundary points captured on the scene boundaries and to display a reconstructed geometry of the boundaries of the 3D model; and to display the set of element points captured on an element of the scene contents and to display one or more element models which match the captured element points.

A method or GUI according to preferred embodiments of the present invention can comprise any combination of the previous system aspects, and in general any feature or combination of features of one aspect can be applied to any or all of the other aspects. Methods according to these further embodiments can be described as computer-implemented in that they require processing and memory capability. The GUI is effectively a programming component, providing a user interface in combination with input hardware and display functionality for the user and input software and/or hardware for data transfer within the capture system.

The system according to preferred embodiments is described as configured or arranged to carry out certain functions. This configuration or arrangement could be by use of hardware or middleware or any other suitable system. In preferred embodiments, the configuration or arrangement is by software.

Thus according to a further aspect there is provided a program which when executed carries out the method steps according to any of the preceding method or GUI definitions or any combination thereof.

The invention can be implemented as a computer program or computer program product, i.e., a computer program tangibly embodied in an information carrier, e.g., in a non-transitory machine-readable storage device or in a propagated signal, for execution by, or to control the operation of, one or more hardware modules. A computer program can be in the form of a stand-alone program, a computer program portion or more than one computer program and can be written in any form of programming language, including compiled or interpreted languages, and it can be deployed in any form, including as a stand-alone program or as a module, component, subroutine, or other unit suitable for use in a data processing environment. A computer program can be deployed to be executed on one module or on multiple modules at one site or distributed across multiple sites.

Method steps of the invention can be performed by one or more programmable processors executing a computer program to perform functions of the invention by operating on input data and generating output. Apparatus of the invention can be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

The invention is described in terms of particular embodiments. Other embodiments are within the scope of the following claims. For example, the steps of the invention can be performed in a different order and still achieve desirable results.

Elements of the invention have been described using the terms "module" and "input", which represent a functional part. The skilled person will appreciate that such terms and their equivalents may refer to physical parts of the system that are spatially separate but combine to serve the function defined. Equally, the same physical parts of the system may provide two or more of the functions defined. For example, separately defined modules may be implemented using the same memory and/or processor as appropriate.

Each of the functional modules may be realised by hardware configured specifically for carrying out the functionality of the module. The functional modules may also be realised by instructions or executable program code which, when executed by a computer processing unit, cause the computer processing unit to perform the functionality attributed to the functional module. The computer processing unit may operate in collaboration with one or more of memory, storage, I/O devices, network interfaces, cameras (either via an operating system or otherwise), and other components of a computing device, in order to realise the functionality attributed to the functional module. The modules may also be referred to as units, and may correspond to steps or stages of a method, program, or process.

### Brief Description of the Drawings

Reference is made, by way of example only, to the accompanying drawings in which:
Figure 1 is an overview of the invention aim in schematic form;
Figure 2 is an example of the use of an invention embodiment;
Figure 3 is a general diagram of a capture system according to invention embodiments;
Figure 4 is a flowchart of a method according to invention embodiments;
Figure 5 is a flow diagram of capture flow enclosed in an invention embodiment;
Figure 6 is a cumulative view of model production;
Figure 7 is a detailed flowchart relating to boundary capture;
Figure 8 is a plan view of captured points and a constructed boundary;
Figure 9 is a schematic representation of captured points on a wall and window;
Figure 10 is a schematic diagram related to computation of room geometry;
Figure 11 is a schematic diagram of a room with an example of boundary capture;
Figure 12 is a detailed flowchart of room contents capture according to an invention embodiment;
Figure 13 shows one screen of a GUI according to invention embodiments as used during contents capture; and
Figure 14 shows various screen views of a GUI according to invention embodiments.

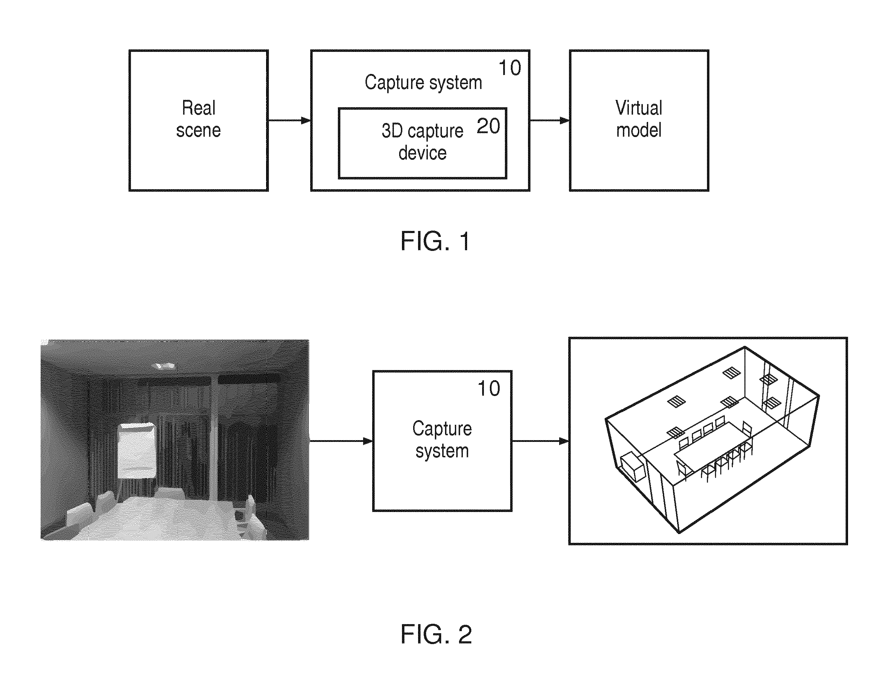

Figure 1 shows the role of invention embodiments in capturing and processing points using a 3D capture device. The capture system is shown as block 10 and the 3D capture device as block 20. The 3D capture device 20 is shown as part of the capture system but may be provided separately. The capture system 10 converts a real scene to a model, referred to here as a virtual model.

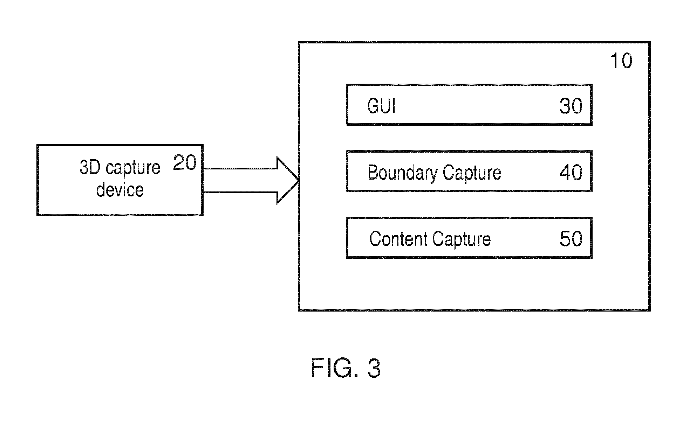

As shown in Figure 1, 3D geometry data resulting from the use of a 3D capture device (e.g. Microsoft Kinect, Occipital Structure Sensor, etc.) is converted into a virtual model of the scene. This virtual model could be later used for simulation, 3D visualization etc. One potential benefit of the capture system of this invention embodiment lies in the capturing and reconstruction process - the way in which a 3D capturing device is used in combination with a GUI and a database to convert the captured scene into a 3D model.

An example of the system in action is shown in Figure 2, where a 3D scene consisting of the real room (with walls, contents and fixtures) is converted into a 3D model. The walls, ceiling and floor are the scene boundaries and are interrupted by a simple door and three windows. The contents are the table and chairs and a cabinet (just seen adjacent to the door). In the real scene, there is a white board which is another object, but has not (yet) been captured.

An embodiment of the current invention solves or at least mitigates the problems in the prior art by using a different scanning process as explained below. This new process can use a different order of operation, and makes use of a GUI and a model database.

Figure 3 shows the capture system with an input from capture device 20. The diagram shows the GUI 30 within the capture system, which is helpful for the user to input/view captured points and/or the model during construction but can also direct the user to capture points in a certain order, (for example to capture the geometry first and once this is complete to capture the contents of the room). The capture system includes 2 modules which process sets of points. The boundary capture module (or functionality) 40 is used solely for points on the boundaries and the content capture module (or functionality) 50 is used solely to process element points on elements/objects within the scene.

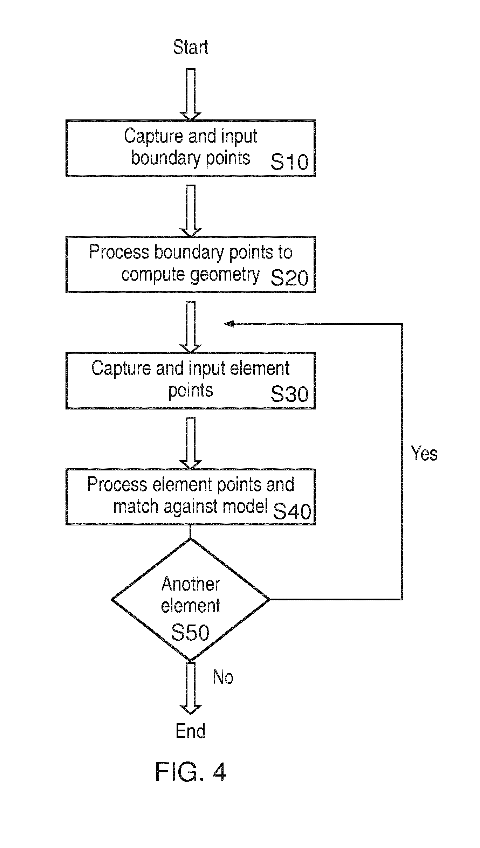

Figure 4 is an overview flow diagram of a method according to invention embodiments. In step S10 boundary points are captured and in step S20 the boundary points are processed to compute the geometry of a scene. In step S30 there is the capture and input of element points and in step S40 element points are processed and matched against the model. In step S50 it is determined if there is another element and if so points corresponding to that element are processed; if not the method finishes.

The GUI allows the user to input captured points specifically as boundary points, or specifically as element points. This may be effected by an order of processing or by any other method in which the points may be identified, for example by way of user input distinguishing the types of points from each other. The user may view the points on a GUI as they are captured for a first stage, for example to capture boundary points and then move to a second stage in which contents are captured using element points.

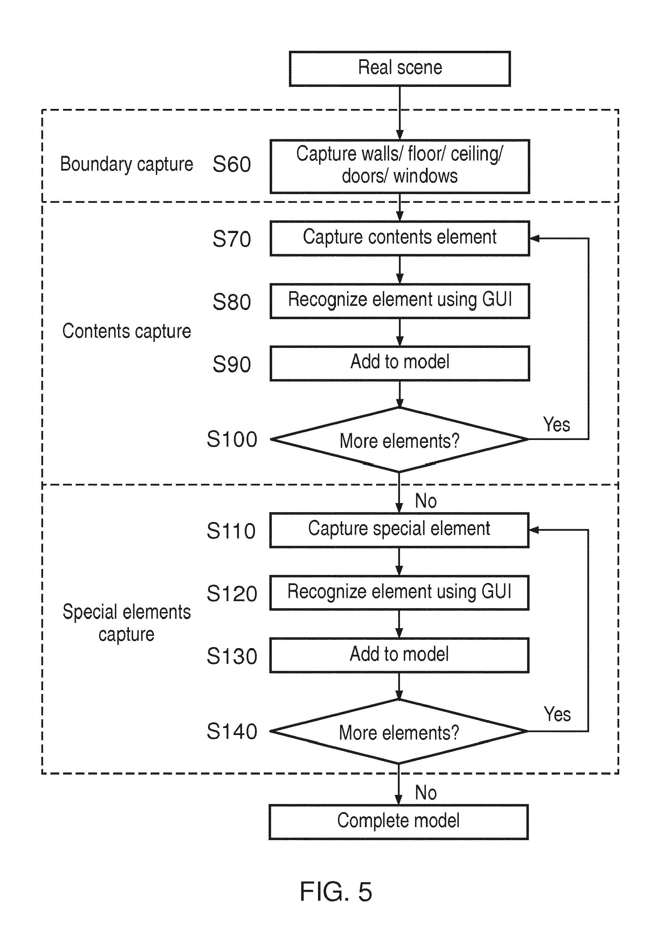

The flow of the 3D capture system proposed in an invention embodiment is shown in Figure 5. The capture of the scene is split into three independent stages:
1. Boundary capture: this is the capture of the walls, floor and ceiling together with any existing doors and windows. There may be a diamond decision box (not shown) at the end of this stage for input of more boundaries, particularly for scenes of complex shape.
2. Contents capture: this is the capture of all elements found in the scene, perhaps with the exception of a few "special" elements (see step 3)
3. Special elements capture: this is an optional stage of the capture of a small subset of the elements that are especially important for the application. For example, if the application is simulating heat propagation inside a room, heat sources like heaters and air conditioners could be the special elements. If the application is simulating light propagation, then the special elements could be the light fixtures.

The reasons for splitting the capturing process into the stages above may be that splitting the elements of the scene into two or three categories makes segmentation much easier, and that it allows us to customize the capturing process for each category as required.

In more detail, starting with a real scene, the first boundary capture stage shows the captured walls, floor, ceilings, doors and windows in step S60. The contents capture phase includes step S70 to S100. In step S70 a content element is captured, which is recognised in step S80 using the GUI, and is added to the model in step S90. In step S100 there is a question as to whether there is more elements, if so the process returns to step S70, if not the process will continue to optional special elements capture stage 3 which comprises steps S110 to steps S140. This stage repeats the contents capture stage but specifically for special elements, for example which may be captured using a different capturing technique. If there are no special elements remaining, the model is complete.

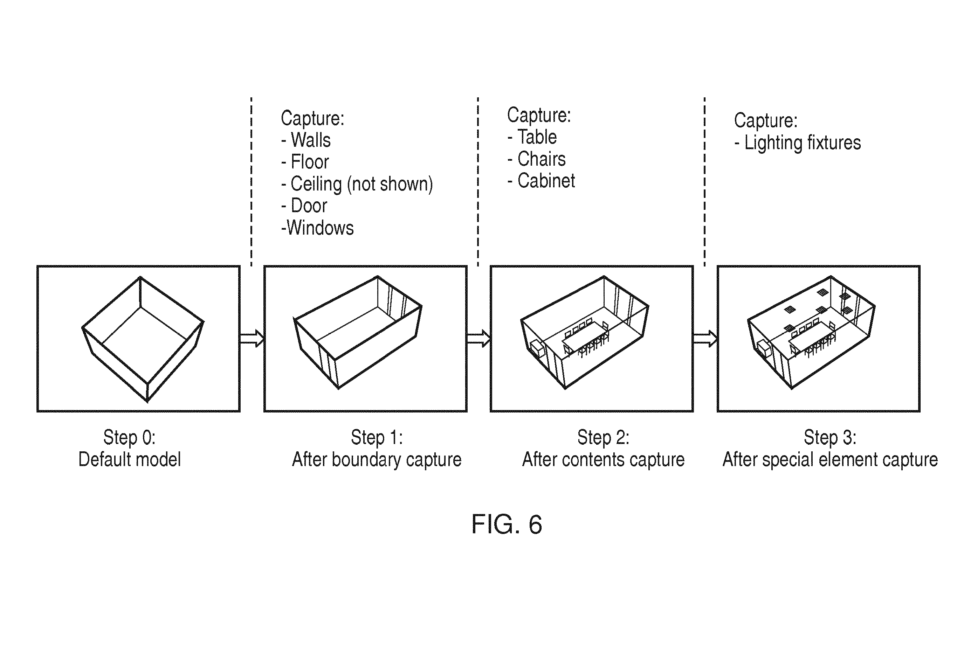

Figure 6 shows an example of how the capture process proposed by an invention embodiment is used to create a model of a room. The process starts at Step 0 with a default model of the room. In this example, the default model has a square shape (4 walls), a floor and a ceiling (not shown). However, the default model can be set to any configuration suitable for the required application. The process proceeds with Step 1, the boundary capture. At this step, the walls (height and width), floor and ceiling (which can be completely determined by the dimensions of the walls) are captured and added to the model to adjust the default model boundaries to the correct size and shape. Also 3 windows and 1 door are captured and added to the model. Next, in Step 2, the contents of the room are captured. In this example the contents consist of 1 table, 10 chairs and 1 cabinet (just visible).

Finally, in Step 3 the ceiling-mounted lighting fixtures are captured as special elements. The "special" category includes elements which may be captured differently from the general room contents. For example, for lighting fixtures, the transparency, reflectiveness or the fact that the lighting fixtures emit makes capturing difficult, so a different capturing algorithm may be required. Hence, one purpose of the separation between special elements and other elements is the possibility of using a specialized capturing method rather than a smaller database.

The following sections look at the capture stages in more detail.

### Stage 1. Boundary capture

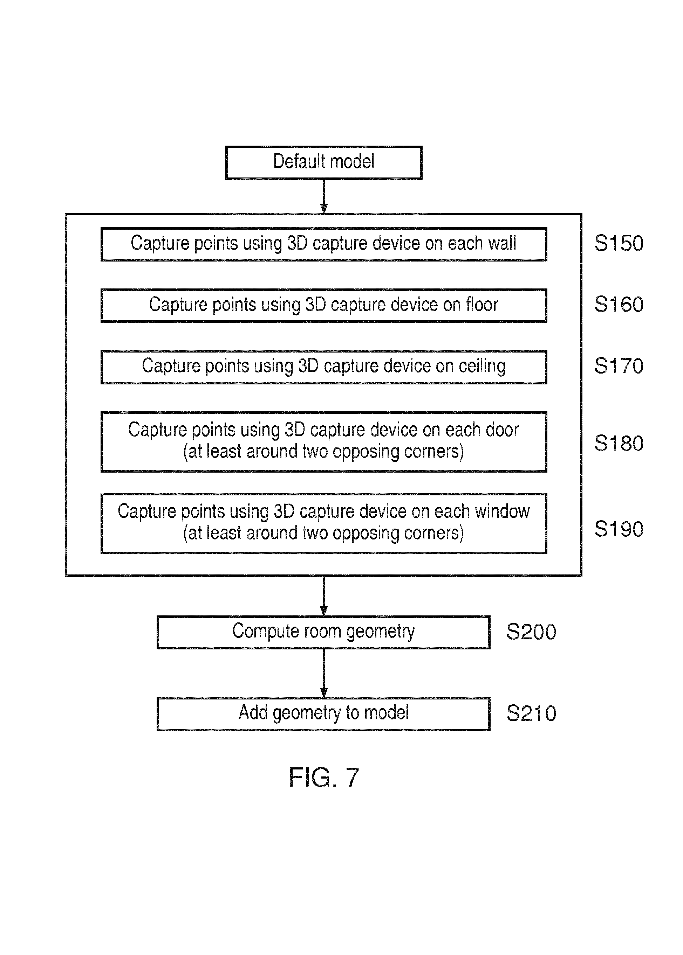

The first stage of the capturing process is the boundary capture (shown in Figure 7) in which walls, floor, ceiling, doors and windows are captured and added to the 3D model. This step starts with an application-specific default model. As an example, if the application is aiming to simulate light distribution inside one room, one possible default model is an empty room of average size. In general, this and other values may either be inputted by the user or read from a database of initial settings. The values are only used to initialize the default model with reasonable assumptions. The model is then updated as more information becomes available.

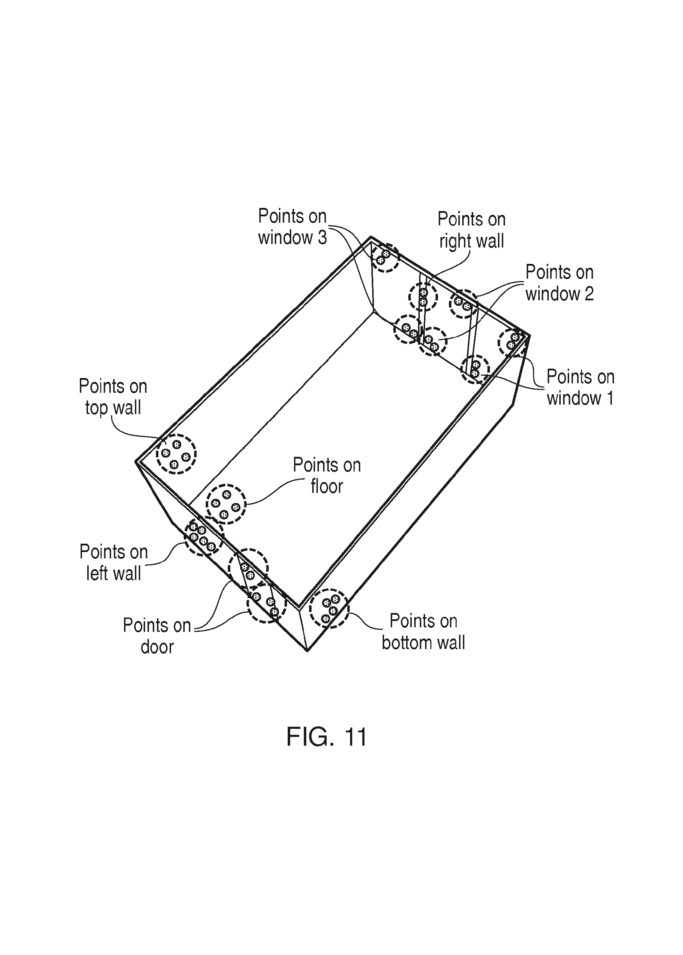

During boundary capture, the user (model creator) points the 3D capture device at every boundary element, where by boundary elements we refer to walls (S150), floor (S160), ceiling (S170), doors (S180) and windows (S190). Following capture, the system will acquire multiple sets of points, with at least one set for each boundary element. An example of this is shown in Figure 11 (described later), where the user captures small sets of points on each boundary element. Note that this embodiment does not require the sets of points to be captured in any particular order. It is expected that they will be captured in a way that is most convenient for the user, for example in a clock-wise or counter-clockwise movement throughout the scene. In one embodiment, the capture is boundary by boundary.

Following the capture process, the geometry of the model is computed from the sets of points that were captured as shown in step S200 and S210 in Figure 7. Although this is shown as two steps, S200 "compute room geometry" and step S210 "add geometry to model", the default model can usually be seen as a set of assumptions, which are used when computing the geometry, in which case step S210 is redundant.

The first step is to compute the geometry of the walls. This is performed as a fitting operation: planar (or curved) surfaces are fitted through the coordinates of the points. The intersections of these surfaces form the corners of the room. As long as there are some points on the floor, ceiling and on each wall, finding the geometry of the walls is a well-posed mathematical problem which can be solved with classical mathematical tools. In the case when points are missing, the system can either use defaults or return an error.

Once the geometry of the walls has been calculated, the system proceeds to the next step - the computation of the positions of doors and windows. The information used at this stage is both 3D coordinate information and color information. In other words, we can detect the presence of a door or a window either using a discontinuity in the depth coordinate or in color or both. Such a discontinuity is expected since windows are transparent and doors often have a different color than the wall they belong to. Moreover, both usually have a frame. Methods of detection can be found in image processing libraries such as OpenCV. Such image contour detection methods can be applied here since the image or door boundary detection problem is a 2D problem - as we already know the supporting surfaces (the walls) from the previous step.

For simplicity, capturing method embodiments can assume that the walls do not contain alcoves or major indentations. It may be assumed that walls are straight, however they do not need to be at a 90% angle from each other. In other words, if a polygon represents the perimeter of the floor and it is extruded in the Z (vertical) direction this produces the room.

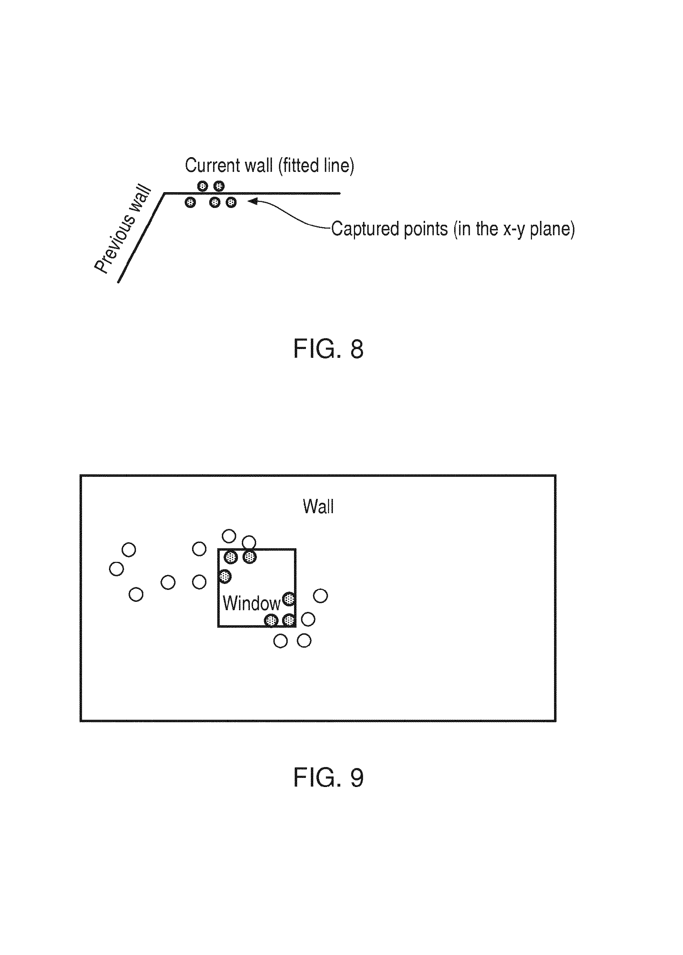

As the user captures points on the walls, the system uses the X and Y coordinates to define the equation of the supporting plane (actually this embodiment only needs to detect a line for each wall, because of the assumptions used). Such a process is shown in Figure 8, which is a plan view.

Figure 8 shows a previously computed wall, and a new wall being fitted to the captured points. The system in this embodiment can detect the fact that a new wall is being scanned using the angle between the supporting planes (i.e., new wall if more than a threshold, for example 20 degrees).

Here, the shape of the floor and ceiling is fully determined by the walls, but some captured points are required on the floor and ceiling to compute the height of the room (by subtracting the Z coordinates of these points).

In Figure 7, separate stages are shown to mark the tasks that must be accomplished. However, in some embodiments the order of the tasks may not be important and, at the end of room geometry capturing stage (the large box in Figure 7) the system may be provided with one point cloud (a single overall set of points). The room model may then constructed based on this point cloud. For example, separation of the points into individual walls can be done using surface angles (this is similar to the way mesh viewers segment surface mesh into individual surfaces).

Hence, the user does not need to tell the system difference between walls, floor and ceiling. The system can find the information based on height information (min and max height for floor and ceiling) and angle information (for walls). The software assumes that the floor and ceiling are flat and parallel to one another.

For doors, the precise capture method can be defined by software (the capture application running on the capture system). For example, if the GUI instructs the user to leave all doors partially opened (hence at an angle with the walls) the system can use this depth information for detection. Also, if it is assumed that doors have a different colour, this information can be used alternatively or additionally. As a more general solution, the GUI can instruct the user to leave at least partially open the doors which have a similar (or almost the same) colour as the supporting walls.

Windows are more difficult to capture with the consumer scanning solutions available today. With technology like Kinect, the infrared light will not be reflected and the windows will appear as holes in the wall. In this case, gaps in walls can be considered windows. In such cases, (and possibly as a general principle) the GUI may instruct the user to capture points on the wall (and/or on the window) as close as possible to the window frame so that the size of the gap is as close as possible to the real window.

The GUI may instruct the user to capture the opposing corners of doors and windows. For example, if a hole in the wall is detected and the system assumes that might be a window, the GUI can instruct the user to capture points as close as possible to the opposite corners.

Image contour detection for the doors and windows can be carried out in the point cloud obtained after the scanning process. For example, after assigning sets of points to walls (based on a segmentation using on angle information), within the points assigned to each wall, colour information can be used to detect doors and windows. An example for a window is shown in Figure 9 where circles with white colour inside represent points captured on a white wall while circles with black colour represent points captured for the window (a hole is detected as black because nothing is reflected back). The size of the window is then approximated from the border between the white and black regions.

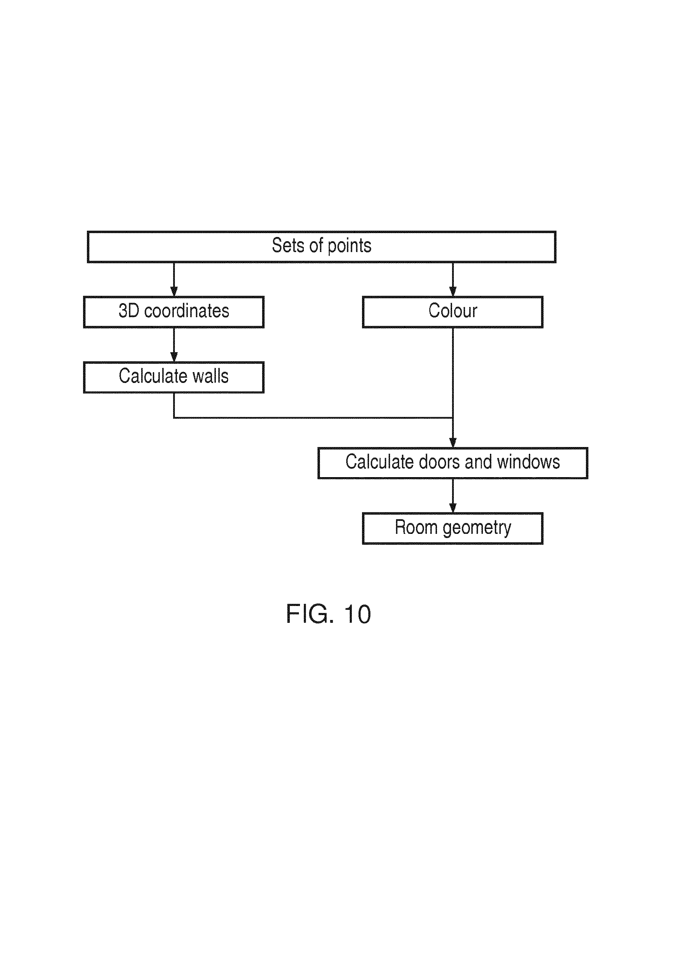

Figure 10 is an overview diagram, showing how the parameters relating to the sets of boundary points can be used in segmentation of door, windows and walls. Wall segmentation requires 3D coordinates only, whereas doors and windows are segmented subsequently, potentially also using colour information.

In all of this embodiment, it is assumed that wails are perpendicular to the floor and straight, and that floor and ceiling are parallel to one another and perpendicular on the walls. The embodiment can also assume a very restricted set of shapes for doors and windows, for example rectangle for doors and rectangular and circular for windows.

Figure 11 shows an example of a boundary capture embodiment. The points shown represent sets of points captured with a 3D capturing device such as the Microsoft Kinect. There is a set of points on the ceiling, however for clarity reasons this is not shown in the diagram.

One benefit of the method in the embodiments outlined above is that one does not need to capture all the bounding geometry of a scene, but only the required minimum. As compared to prior art, this has become possible partly because of the limited scope of the capturing process to the boundaries of the scene (that is floor, ceiling, walls, doors and windows). By narrowing this scope it is possible to make additional assumptions about the shape of the target objects, which in turn allows a reduction in the amount of scanned information.

### Stage 2. Contents capture

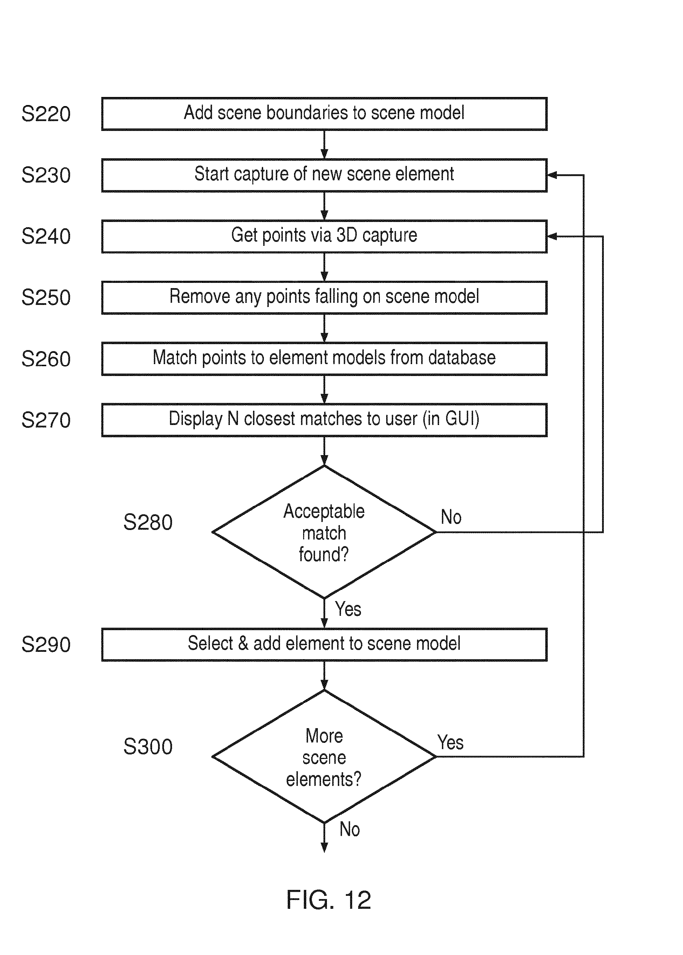

The second stage is the capturing of the contents of the room. This can be carried out element by element, for which the system performs 3D capture, segmentation and recognition. This process (shown in Figure 12) follows the steps below.

The contents capture process starts with an empty scene model to which are added (or have already been added) the scene boundaries (such as any of floor, ceiling, walls, doors and windows) that were computed in the previous stage. Subsequently, the uses targets one component in the scene (e.g. a chair) in step S230 and uses the 3D capture device to capture points on this component (S240). Inadvertently, points which do not belong to this component will be captured as well, for example points which are part of the floor, walls or other components in the neighborhood. Most of these undesired points can be removed by computing which points from the captured set fall on entities found in the (incomplete) scene model and removing those that do. By this procedure, points which fall on floors or walls will always be removed as these entities will always be present in the scene model. Moreover, points that fall on already captured elements will be removed as well.

After this "clean-up" of the capture points set, the method in this embodiment uses algorithms known in the art to match the set of points with models from a model database. A matching score is assigned and a GUI shows to the user the first N models (for example N=3) that match best. The user can then input a model selection, or an indication that no model is selected (S280). If the user is satisfied with one of the models shown, the user choses the model (for example, by click or touch), which will then be added to the scene model in step S290. If no models are appropriate, the scanning operation is continued (S240). As more points are captured, a more complete and accurate match can be performed. The process continues with the user input that there are no more elements in step S300. This process finishes when all components have been captured.

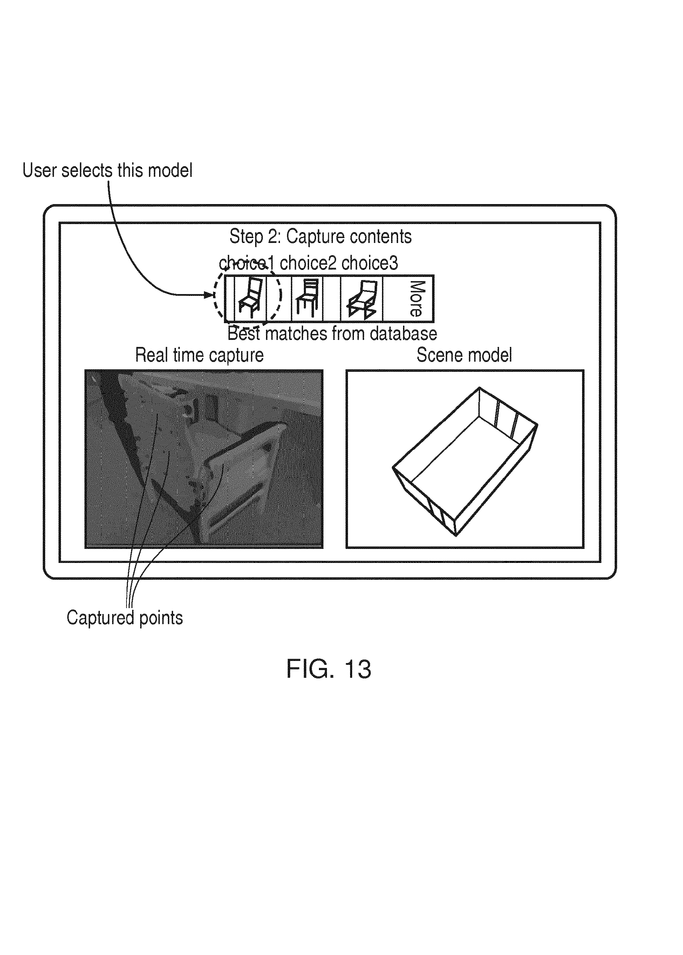

The capture contents stage may use a GUI such as the one shown in Figure 13. In the bottom left part of the screen, the user can see the output of the real time capture. This information is used to guide the user through the capturing operation. The top of the screen shows the first 3 models (N=3 in this case) in the database that best match the set of scanned points. This part of the screen updates as new scanned points become available. Once an acceptable model is displayed, the user selects the model (in this case Choice 1), which is then added to the "Scene model" found in the lower right part of the screen.

### Optional stage 3. Special elements capture

The capture of special elements uses the same procedure as with contents capture. For optimization purposes, one may use a different database containing only relevant models instead of using the full database.

### Graphical User Interface, GUI through the Capturing stages

At the most general level, capturing (including special elements in this example) should be done in 3 consecutive stages: boundary capture, contents capture and special elements capture.

During capturing the following information is displayed:
1. During boundary capture, a real-time capture window (for example the points on a scene image) and a constructed geometry window are shown. They could be shown side-by-side (as in Fig. 13) or the reconstruction could be superimposed on the live capturing.
2. During contents capture and special element capture, beside the elements from point 1, a list of possible candidates is shown, ordered by matching probability. Again, here the reconstructed component could be super-imposed on the live capturing.
3. During all stages, there is a button which the user can use to move to the next stage (thus marking the current stage as complete).

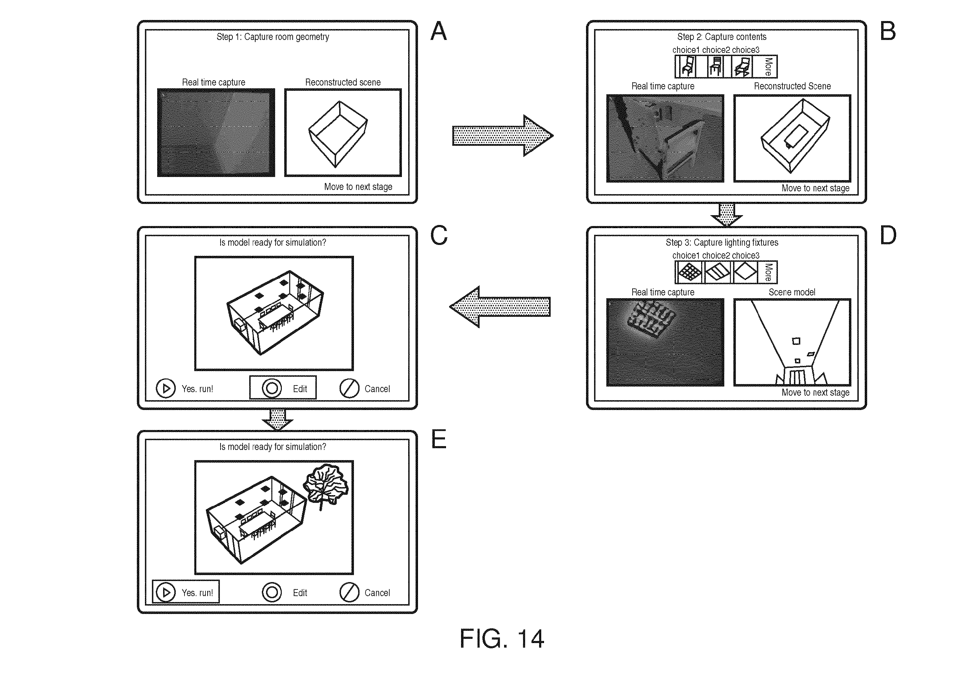

Figure 14 shows various possible screen configurations for a GUI during the different stages of capture. Screen A can be used during the stage of capturing a room geometry. On one side of the screen real-time capture can be viewed, and the reconstructed scene is produced on the other side. There is also a button available for moving to the next stage. In screen B the methodology is advanced to capturing contents and thus in addition to the elements mentioned for screen A, the user is provided with a number of potential matches for the element currently being captured. This screen can also contain a button to select a model, or a mouse click may select a model. In screen C, there is the step of capturing a special element in the form of the lighting fixtures. The same layout and considerations apply as for screen B. In the following stage, shown in screen D, the user is asked if the model is ready for simulation. At this stage the model only is viewed but there is a possibility of editing the model, cancelling or running the model shown as buttons at the bottom of the screen. The user has highlighted the edit button. Screen E indicates that the model has been edited, by addition of a tree outside the room which is relevant to the light simulation. The user has highlighted the run button.

### Model matching

A key feature of the current invention is the use of a model database to assist the scanning process. Matching is done using methods known is the art, for example the OpenCASCADE BestFitmodule(http://www.opencascade.org/support/products/bestfit/). Alternatively, if during scanning of an element a barcode could be detected, the barcode could be used to identify the object and obtain the appropriate CAD model from the seller or manufacturer.

Matching can be carried out either on the local machine (e.g. tablet or laptop) or as a cloud service. In the case of a cloud service, the local application can send the coordinates of a set of points in 3D space to the cloud service and in response it will get either one or more model files or a descriptor (e.g. ID or URL) of a location containing one or more model of the scanned element. Also, in the case of a cloud service, part of the database could be cached locally.

## Claims

1. A capture system arranged to create a 3D model from a scene and comprising:
an input from a 3D capture device which captures sets of points in the scene corresponding to scene boundaries and one or more scene elements;
a Graphical User Interface, GUI configured to allow input of a set of points specifically as boundary points and configured to allow input of a set of points specifically as element points;
a boundary capture module configured to process sets of boundary points captured on the boundaries and to compute the geometry of the boundaries of the 3D model; and
a content capture module configured to process the set of element points captured on an element of the scene contents and to match the captured points for the element against element models in a model database.

2. A capture system according to claim 1, wherein
the scene is a room and the boundary capture module is configured to process boundary points for the walls, ceiling and floor in combination to compute the wall geometry by fitting intersecting surfaces through sets of points.

3. A capture system according to claim 1 or 2, wherein
the boundary capture module is configured to compute the positions of doors and windows once the wall geometry has been computed, by using 3D coordinate information and/or colour information.

4. A capture system according to any of the preceding claims, further comprising:
a database configured to store a default scene model; wherein
the boundary capture module is configured to base the computed geometry of the boundaries of the 3D model on the default scene model.

5. A capture system according to any of the preceding claims, wherein
the content capture module is configured to process one set of element points and add an element to the 3D model before processing a next set of element points.

6. A capture system according to any of the preceding claims, wherein
the content capture module is configured to subtract from a set of element points currently being processed any point belonging to a previously captured boundary or scene element.

7. A capture system according to any of the preceding claims, wherein
the GUI is configured to allow input of the boundary points and computation (and display) of the geometry of the boundaries of the 3D model before input of the element points.

8. A capture system according to any of the preceding claims, wherein
the GUI is configured to allow the user to select an element model for insertiosn in the 3D model, from pre-selected element models in the model database which match the captured element points on an element.

9. A capture system according to claim 8, wherein
the GUI is configured to allow the user to reject all of the pre-selected element models and to continue capturing points on the element.

10. A capture system according to any of the preceding claims, wherein
the content capture module is configured to match the captured element points on an element against element models in a model database and to provide a matching score by which up to N candidate element models are preselected.

11. A capture system according to any of the preceding claims, wherein
the content capture module is configured to match the captured points on an element by sending the set of points to an external matching service and receiving one or more matched element models or the network location of one or more matched element models in return.

12. A capture system according to any of the preceding claims, further comprising:
a special element capture module configured to process special element points captured on predefined special elements of the scene contents using a different capturing algorithm from a capturing algorithm used for other element points and to match the captured element points for each predefined special element against special element models in a model database.

13. A capture system according to any of the preceding claims, wherein
the GUI is also configured to allow the user to input when a stage of boundary capture and/or contents capture and/or special element capture is complete.

14. A method of creating a 3D model from a scene having scene boundaries and one or more scene elements, the method comprising:
inputting via a Graphical User Interface, GUI a set of boundary points for each scene boundary corresponding to the boundary from a 3D capture device; and
processing the sets of boundary points captured on all the boundaries and computing the geometry of the boundaries of the 3D model; and subsequently
for each scene element:
inputting via a GUI a set of points corresponding to the scene element from the 3D capture device; and
processing the set of element points captured on the element and matching the captured points against element models in a model database.

15. A Graphical User Interface, GUI, in a capture system arranged to create a 3D model from a scene with scene boundaries and one or more scene elements using a 3D capture device which captures sets of points in the scene; wherein the GUI is configured:
to allow the input of one set of points specifically as boundary points and the input of another set of points specifically as element points;
to display the sets of boundary points captured on the scene boundaries and to display a reconstructed geometry of the boundaries of the 3D model; and
to display the set of element points captured on an element of the scene contents and to display one or more element models which match the captured element points.
